# EUROPEAN PATENT APPLICATION

(11) **EP 3 151 225 A1**
(43) Date of publication of application: **05.04.2017**
(21) Application number: 15799606.7
(22) Date of filing: 28.05.2015
(51) Int. Cl.: G09G 3/20, G09G 3/32, G09G 3/36, G11C 19/00

(54) **SHIFT CIRCUIT, SHIFT RESISTOR, AND DISPLAY DEVICE**

(30) Priority: 28.05.2014 KR 20140064275; 01.12.2014 KR 20140169835
(71) Applicant: Kolonauto Co., Ltd, Chungcheongnam-do 32210 (KR)
(72) Inventor: MOON, Hye-Ji, Asan-si Chungcheongnam-do 336-824 (KR)
(74) Representative: Merkle, Gebhard
(86) International application number: PCT/KR2015/005332
(87) International publication number: WO 2015/182998

(57) **Abstract**

The present invention comprises: a shift circuit BCₖ of a shift resistor which has a first state and a second state and includes a plurality of shift circuits that are cascade-connected; an output terminal OUT which outputs a state signal indicating any one of the first state and the second state; an output control transistor T₁₃ in which a clock signal is applied to a second electrode, and a third electrode is connected to the output terminal; a charge means C_{Q} connected between a first electrode and a first node Q of the output control transistor; a set transistor T₁₁ which activates the first node based on a state signal output from a shift circuit BCₖ₋₁ in a previous stage of the plurality of shift circuits and charges the charge means; and a reset transistor T₁₅ which deactivates the first node based on a state signal output from a shift circuit BCₖ₊₁ in a next stage of the plurality of shift circuits.

## Description

### [Technical Field]

The present invention relates to a shift circuit, a shift register including the shift circuit, and a display device including the shift register.

### [Background Art]

Recently, an active driving type flat panel display device such as an organic light emitting display (OLED) or a liquid crystal display (LCD) has been generally developed and distributed, and in order to miniaturize a display device and reduce manufacturing costs, a display device in which a display unit including a pixel circuit and a gate driver for driving a gate line (scanning line) are formed on the same substrate has been developed. The active driving type display device generally uses a shift register as the gate driver.

As such the shift register, a gate driver using an amorphous silicon thin film transistor referred to as a so-called Thomson type shift register has been known in the art (Non-Patent Document 1).

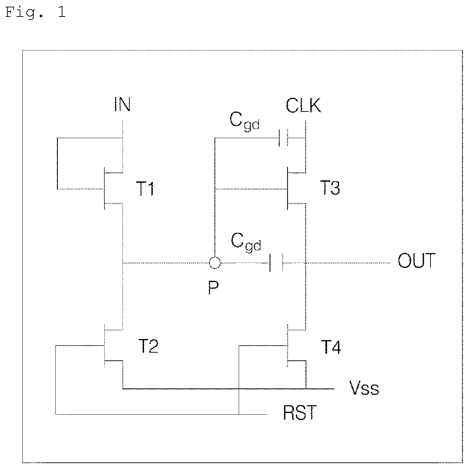

FIG. 1 is a circuit diagram showing a configuration of a conventional shift register described in Non-patent document 1.

The shift register of FIG. 1 includes transistors T1 to T4 made of amorphous silicon. When a start signal is input to an input terminal IN, the transistor T1 is turned on such that electric charge is charged to a P-node thereby applying a voltage decreased to a threshold voltage of the transistor T1 to a gate of the transistor T3. In this case, when a clock signal CLK applied to a clock terminal is changed from a low level to a high level, a voltage of the P-node in a floating state is subjected to coupling interference by parasitic capacitance C_{gd} and C_{gs} of the transistor T3. Therefore, the P-node is bootstrapped at a high threshold voltage, and thereby the clock signal CLK is output through an output terminal OUT.

Then, when an output in a next stage is input to a reset terminal RST, the transistors T2 and T4 are turned on, then the electric charge charged to the P-node and the electric charge of the output terminal OUT are discharged only during a pulse width period of a reset signal, and the floating state is maintained until the next period.

Meanwhile, introduction of an oxide thin film transistor (TFT) to a driving circuit of the display device has been attempted in recent years. In addition, since the oxide TFT has advantages of having high mobility, large on-current, and excellent transparency, as compared to the TFT using the amorphous silicon as a semiconductor material, in particular, the organic TFT is used as a material for a TFT of a display device (TOLED) using a transparent organic EL device for the pixel circuit.

However, the oxide TFT has a critical disadvantage that a threshold voltage is lower than 0 V, thereby causing a difficulty in application to the circuit.

For example, when forming the conventional shift circuit of FIG. 1 by the oxide TFT, since the threshold voltage of the transistors T1 to T4 made of the oxide semiconductor material is lower than 0 V, even when the output in the next stage is input to the reset terminal RST, the transistor T3 is not completely turned off, but the clock signal is partially output to the output terminal OUT whenever a clock CLK is turned on and off, and thereby causing an abnormal increase in an output voltage.

### [Prior Art Document]

### [Non-Paten Document]

Non-patent Document 1: Study on reliable integrated gate driver circuits using hydrogenated amorphous silicon TFTs, Kwon, Min-sung, 2009. 2. Kyunghee University

### [Disclosure]

### [Technical Problem]

It is an object of the present invention to provide a shift circuit for preventing problems entailed in the related art that an output of an output terminal is abnormally increased according to turn-on and turn-off of a clock even when the shift circuit is in a reset state, a shift register including the shift circuit, and a display device including the shift register.

### [Technical Solution]

In order to accomplish the above object, according to an aspect of the present invention, there is provided a shift circuit of a shift register including a plurality of shift circuits that are cascade-connected, the shift circuit including: an input circuit which includes an input terminal to which an output signal of a shift circuit in a previous stage is supplied as an input signal, a reset terminal to which an output signal of a shift circuit in a next stage is supplied as a reset signal, and a first node, and is configured to set a potential of the first node as a potential of the input signal, as the input signal is input; an inverting circuit including a second node and a reference voltage terminal, wherein the second node is configured to have a potential that is reverse to the potential of the first node obtained by reversing the potential of the first node; an output circuit which includes a first clock terminal to which a first clock signal is supplied, and an output terminal which outputs the output signal, and is configured to output a potential of the output signal as a potential according to the first clock signal to the output terminal depending on the potential of the first node and the potential of the second node; and a hold circuit configured to maintain the potential of the second node as a high level potential when the potential of the first node is not the potential of the input signal.

According to another aspect of the present invention, there is provided a shift circuit of a shift register which has a first state and a second state and includes a plurality of shift circuits that are cascade-connected, the shift circuit including: an output terminal configured to output a state signal indicating any one of the first state and the second state; an output control transistor in which a clock signal is applied to a second electrode, and a third electrode is connected to the output terminal; a charge means connected between a first electrode and a first node of the output control transistor; a set transistor configured to activate the first node based on a state signal output from a shift circuit in a previous stage of the plurality of shift circuits, and charge the charge means; and a reset transistor configured to deactivate the first node based on a state signal output from a shift circuit in a next stage of the plurality of shift circuits.

In addition, according to another aspect of the present invention, there is provided a shift register including a plurality of shift circuits that are cascade-connected, wherein each of the plurality of shift circuits includes the above shift circuit.

Further, according to another aspect of the present invention, there is provided a display device including a light emitting device, the display device including: a plurality of pixel circuits disposed in a matrix form; and the above shift register, and including a row selection driver configured to select the plurality of pixel circuits in a row unit by supplying an output signal of each shift circuit included in the shift register as a row selection signal for selecting a row of the display device.

### [Advantageous Effects]

The shift circuit according to the present invention having the above-described configuration may prevent a problem that the output of the output terminal is abnormally increased according to the turn-on and the turn-off of the clock signal in the reset state when the shift circuit is formed by the transistor having a threshold voltage lower than 0 V, and may certainly separate the reference voltage terminal and the output terminal at the time of output of the shift circuit such that the clock signal may accurately be output to the output terminal, and thereby securing stability of the operation of the shift register. Particularly, when forming the shift circuit using the oxide thin film transistor having a threshold voltage lower than 0 V, stability of the operation may be secured.

### [Description of Drawings]

FIG. 1 is a circuit diagram showing a configuration of a shift circuit of a conventional shift register.
FIG. 2 is diagrams showing a configuration of a display device according to a prepared embodiment of the present invention.
FIG. 3 is a diagram showing a configuration of a shift register of a gate driver of FIG. 2A.
FIG. 4 is a diagram showing a configuration of a shift circuit according to Embodiment 1 of the present invention.
FIG. 5 is a timing chart showing an operation of the shift circuit of FIG. 4.
FIG. 6 is a diagram showing a configuration of a shift circuit according to Embodiment 2 of the present invention.
FIG. 7 is a timing chart showing an operation of the shift circuit of FIG. 6.
FIG. 8 is a diagram showing a configuration of a shift circuit according to Embodiment 3 of the present invention.
FIG. 9 is a timing chart showing an operation of the shift circuit of FIG. 8.
FIG. 10 is a diagram showing a configuration of a shift circuit according to Embodiment 4 of the present invention.
FIG. 11 is a timing chart showing an operation of the shift circuit of FIG. 10.

### [Best Mode]

Hereinafter, preferred embodiments of the present invention will be described in detail with reference to the accompanying drawings.

### 1. Embodiment 1

Hereinafter, a display device according to Embodiment 1 will be described as a display device having a plurality of pixels in which each pixel includes an organic electroluminescent device (hereinafter, referred to as an "organic EL device") as a light emitting device by way of example.

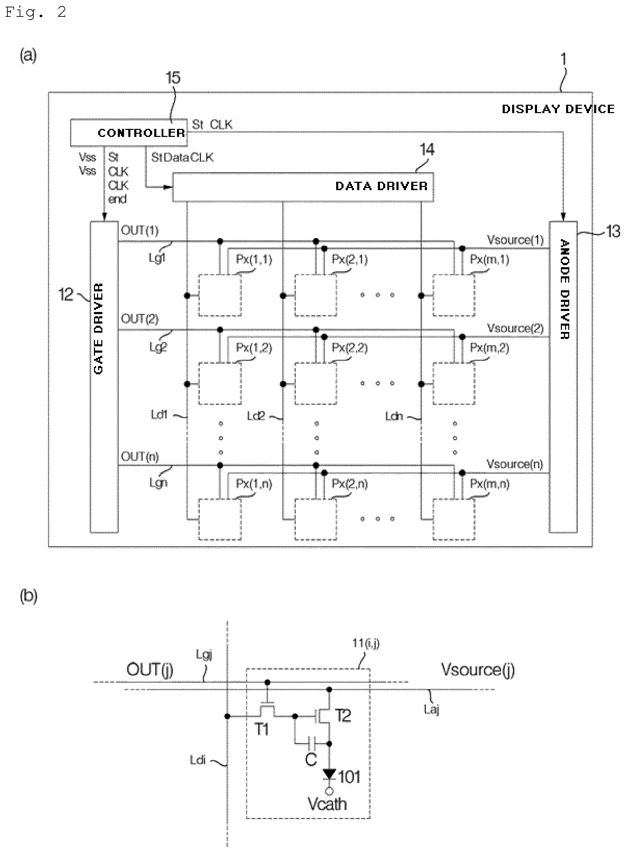

A configuration of the display device according to Embodiment 1 of the present invention is shown in FIG. 2.

As shown in FIG. 2A, a display device 1 according to Embodiment 1 of the present invention includes n rows and m columns of a plurality of pixel circuits Px(i, j) (i = 1 to m, j = 1 to n, and m and n are natural numbers, respectively), a gate driver (row selection driver) 12, an anode driver 13, a data driver 14, and a controller 15.

The pixel circuit Px(i, j) corresponds to each pixel of an image, is arranged in a matrix form, and includes an organic EL device 101, two transistors T1 and T2, and a capacitor C as shown in FIG. 2B.

The capacitor C is a capacitor disposed between a gate and a source of the transistor T2.

The organic EL device 101 is a display device having a structure in which a pixel electrode (anode electrode), an organic EL layer including a single or a plurality of carrier transport layers, and a counter electrode are sequentially stacked, and a cathode potential Vcath is applied to the counter electrode (cathode electrode).

The transistors T1 and T2 are a TFT formed by an n-channel field effect transistor (FET), and have a drain, a source and a gate, respectively, in which a semiconductor layer is disposed between the drain and the source, such that when a predetermined bias voltage is applied between the drain and the source and a voltage larger than a threshold voltage is applied to the gate, a channel is formed in the semiconductor layer to form a current path between the drain and the source by the channel.

The transistor T1 is a transistor for applying an image signal Vdata indicating a gray scale of image data Data to one terminal of the capacitor C. The source of the transistor T1 of each pixel circuit Px(i, j) is connected to the gate of the transistor T2 and one terminal of the capacitor C.

The drain of the transistor T1 of each of the pixel circuits Px(i, 1), ... and Px(i, n) is connected to an i-th data line Ldi, and the gate of the transistor T1 of each of the pixel circuit Px(1, j), ... and Px(m, j) is connected to a j-th gate line Lgj.

Further, when a high-level signal is sequentially output to each of the gate lines Lg1, ... and Lgn, each transistor T1 of the pixel circuits Px(1, j), ... and Px(m, j) is turned on, such that the image signal Vdata input to each of the data lines Ld1, ... and Ldm is output to the gate of the transistor T2 and one terminal of the capacitor C.

The transistor T2 is a transistor controlling a current having an amount based on the image data Vdata and supplying the current to the organic EL device 101, the gate thereof is connected to the source of the transistor T1 and one terminal of the capacitor C, the drain thereof is connected to an anode line Laj, and the source thereof is connected to the other terminal of the capacitor C and an anode of the organic EL device 101.

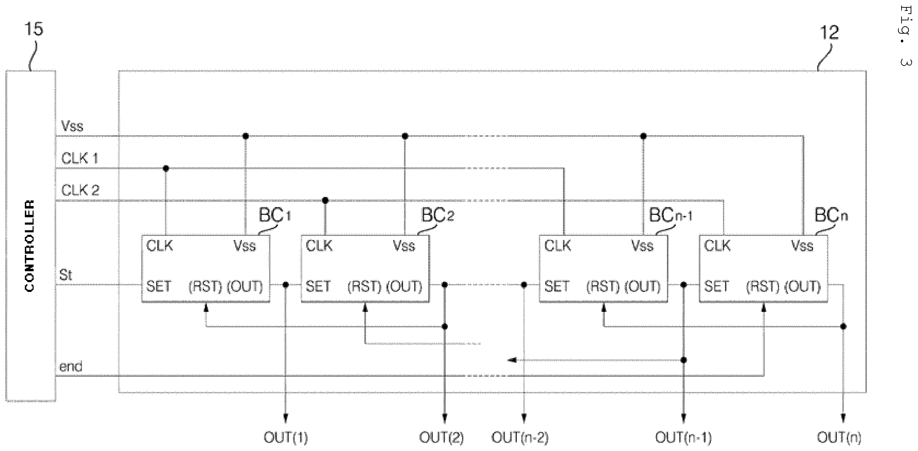

The gate driver 12 is a driver for selecting a pixel circuit Px(i, j) in a row unit, and as shown in FIG. 3, a reference voltage Vss from the controller 15 is applied to the gate driver 12. Further, a start signal St, an end signal End, and clock signals CLK1 and CLK2 are supplied to the gate driver 12.

The gate driver 12 starts an operation by being supplied with the start signal St, sequentially outputs output signals OUT(1) to OUT(n) to the gate lines Lg1 to Lgn according to the clock signals CLK1 and CLK2, and ends the operation by being applied with the end signal End.

Thereby, the gate driver 12 selects the pixel circuits Px(1, 1) to Px (m, 1), ... and Px(1, n) to Px (m, n) in a row unit.

The gate driver 12 has a shift register as shown in FIG. 3, in which the shift register includes shift circuits BC₁ to BCₙ formed in multiple stages (the number thereof is the same as that of the gate lines), and each of the shift circuits BC₁ to BCₙ is formed as a bistable circuit that becomes any one state of two states (a first state and a second state) at each timing, and outputs a signal indicating the corresponding state as a scanning signal.

Further, each of the shift circuits BC₁ to BCₙ includes a set signal input terminal SET for inputting a set signal (including the start signal St), a clock input terminal CLK for inputting a clock signal CLK1 or CLK2, a reset input terminal RST for inputting a reset signal, a reference voltage input terminal Vss for inputting a low level reference voltage, and an output terminal OUT for outputting a scanning signal as an output signal of the shift circuit.

The scanning signal OUT output from each stage (shift circuits BC₁ to BCₙ) of the shift register is applied to a next stage as a set signal SET, and is applied to a previous stage as a reset signal RST. Further, the operation of the shift register starts by the start signal St from the controller 15, and ends by the end signal End.

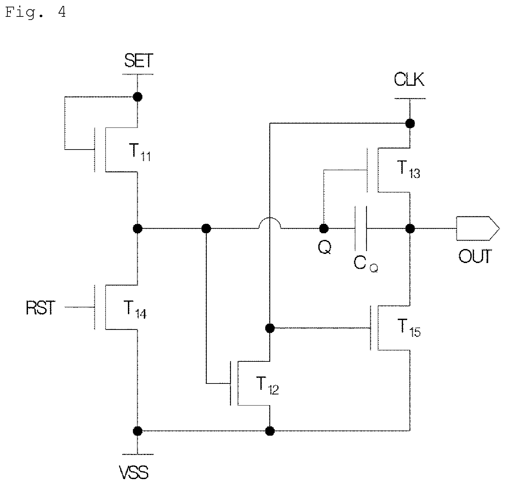

Next, a configuration of the shift circuit BCₖ according to Embodiment 1 will be described in detail with reference to FIG. 4.

FIG. 4 is a diagram showing a configuration of the shift circuit according to the preferred Embodiment 1 of the present invention, and in FIG. 4 and the following description, a specific shift circuit BCₖ of the plurality of shift circuits BC₁ to BCₙ is described as an example, but other shift circuits other than the shift circuit BCₖ are the same as the shift circuit BCₖ.

As shown in FIG. 4, the shift circuit BCₖ includes five transistors T₁₁ to T₁₅, one capacitor C_{Q}, four input terminals and one output terminal.

Each of the transistors T₁₁ to T₁₅ included in the shift circuit BCₖ includes an n-channel FET formed by an oxide TFT.

The transistors T₁₁ to T₁₅ have a gate electrode (first electrode), a drain electrode (second electrode), and a source electrode (third electrode), respectively, in which a semiconductor layer is disposed between the drain electrode and the source electrode, and when a predetermined bias voltage is applied between the drain and the source and a voltage larger than a threshold voltage is applied to the gate, a channel is formed in the semiconductor layer to form a current path between the drain and the source by the channel.

The set signal input terminal SET is a terminal to which a set signal SET[k] is input. Further, the output terminal OUT is a terminal for outputting an output signal OUT[k] of the shift circuit BCₖ, which is connected to a corresponding gate line Lgk. The output terminal OUT of each shift circuit BCₖ is connected to an output terminal OUT of a shift circuit BCₖ₊₁ in the next stage, and the output signal OUT[k] of the shift circuit BCₖ in the previous stage becomes a set signal SET[k] of the shift circuit BCₖ₊₁ in the next stage.

The reset terminal RST is a terminal to which a reset signal RST[k] is applied, and the reset terminal RST of the respective shift circuits is connected to the output terminal OUT of the shift circuit BCₖ₊₁ in the next stage, such that an output signal OUT[k+1] of the shift circuit BCₖ₊₁ in the next stage is applied as the reset signal RST[k] of the shift circuit BCₖ in the corresponding stage.

As such, the output signal OUT[k] of the shift circuit BCₖ in a specific stage is supplied as a scanning signal activating the gate line Lgk corresponding to the corresponding shift circuit BCₖ, and is supplied as a reset signal RST[k-1] of a shift circuit BCₖ₋₁ in the previous stage and as the set signal SET[k] of the shift circuit BCₖ₊₁ in the next stage.

The clock input terminal CLK is a terminal to which the clock signal CLK1 or CLK2 is input, a clock input terminal CLK of a shift circuit in an odd-numbered stage is supplied with the click signal CLK1 from the controller 15, and a clock input terminal CLK of a shift circuit in an even-numbered stage is supplied with the clock signal CLK2 from the controller 15.

The reference voltage terminal Vss is a terminal to which a low level voltage as a reference voltage is applied. It is preferable that the low level voltage as a reference voltage is a voltage lower than a threshold voltage of an oxide transistor, in consideration of the threshold voltage of the oxide transistor in a case in which each of the transistors T₁₁ to T₁₅ included in each shift circuit of Embodiment 1 is formed by the oxide transistor.

A source terminal of a set transistor T₁₁, a drain terminal of a reset transistor T₁₄, gate terminals of a first switching transistor T₁₂ and an output control transistor T₁₃ are connected with each other, and hereinafter, a connection point in which they are connected with each other is referred to as a node Q. Further, one end of the capacitor C_{Q} is connected to the node Q.

A gate terminal and a drain terminal of the set transistor T₁₁ are connected (i.e. diode-connected) to the set signal input terminal SET, and the source terminal thereof is connected to the node Q.

The gate terminal of the first switching transistor T₁₂ is connected to the node Q, a source terminal thereof is connected to the reference voltage terminal Vss, and a drain terminal thereof is connected to the clock input terminal CLK and is also connected to a gate terminal of a pull-down transistor T₁₅.

The gate terminal of the output control transistor T₁₃ is connected to the node Q, a drain terminal thereof is connected to the clock input terminal CLK and is also connected to the drain terminal of the first switching transistor T₁₂ and the gate terminal of the pull-down transistor T₁₅, and the source terminal thereof is connected to the output terminal OUT and is also connected to the other end of the capacitor C_{Q} and the drain terminal of the pull-down transistor T₁₅.

A gate terminal of the reset transistor T₁₄ is connected to the reset input terminal RST, the drain terminal thereof is connected to the node Q, and a source terminal thereof is connected to the reference voltage terminal Vss, and is connected to the source terminal of the first switching transistor T₁₂ and a source terminal of the pull-down transistor T₁₅.

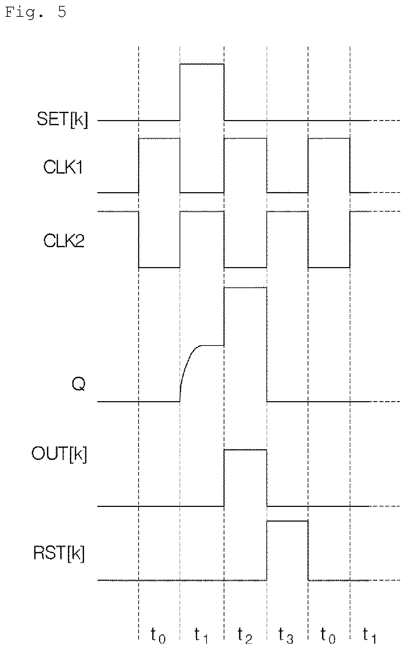

Next, referring to FIGS. 4 and 5, an operation of the shift circuit BCₖ will be described. FIG. 5 is a timing chart showing the operation of the shift circuit of FIG. 4.

First, in a period to of FIG. 5, a potential of the node Q and the output signal OUT[k] of the output terminal OUT is a low level potential. Further, since the pull-down transistor T₁₅ is turned on by a high-level clock signal CLK1 applied to the clock input terminal CLK, and a low level potential from the reference voltage terminal Vss is applied to the output terminal OUT through the pull-down transistor T₁₅, the output signal OUT[k] is reliably maintained at a low level. In other words, in a case in which an oxide TFT having a threshold voltage Vth equal to or lower than 0 V is used as the output control transistor T₁₃, even when the output control transistor T₁₃ is not completely turned off, the pull-down transistor T₁₅ is turned on, thereby it possible to prevent the clock signal CLK from being output to the output terminal OUT.

Next, in a period t₁, a set signal SET[k] is applied to the set signal input terminal SET, and the diode-connected set transistor T₁₁ is turned on to charge the capacitor C_{Q}, and thereby, the potential of the node Q is changed from a low level to a high level, such that the first switching transistor T₁₂ and the output control transistor T₁₃ are turned on, and the pull-down transistor T₁₅ is turned off. However, in the period t₁, since the clock signal CLK1 applied to the clock input terminal CLK is at a low level state, the output signal OUT[k] is not output to the output terminal OUT.

Next, in a period t₂, the set signal SET [k] applied to the set signal input terminal SET is changed to a low level, and the clock signal CLK1 applied to the clock input terminal CLK is increased to a high level. In this case, since the output control transistor T₁₃ is in a turn on state, a potential of the output terminal OUT is also increased, and the potential of the node Q is also increased by the capacitor C_{Q} (i.e. the node Q is bootstrapped). Therefore, the gate terminal of the output control transistor T₁₃ is applied with a potential obtained by adding a potential of the clock signal CLK1 to the potential of the set signal SET[k] charged in the capacitor C_{Q} in the period t₁. As a result, the output control transistor T₁₃ allows the clock signal CLK1 to be output as the output signal OUT[k](scanning signal) without loss through the output terminal OUT, such that a gate line Lgk connected to the output terminal OUT of the shift circuit BCₖ is selected.

In this case, the first switching transistor T₁₂ is continuously maintained in the turn on state, and thus the pull-down transistor T₁₅ is also continuously maintained in the turn off state.

Next, in a period t₃, when a high level reset signal RST[k] is input to the reset input terminal RST, the reset transistor T₁₄ is turned on, and thus the potential of the node Q becomes a low level, such that the first switching transistor T₁₂ and the output control transistor T₁₃ are turned off, and the clock signal CLK1 is not applied to the clock input terminal CLK, therefore, the output signal OUT[k] is not output to the output terminal OUT.

Similar to the above operation, the shift circuit BCₖ uses an output signal OUT[k-1] output from a shift circuit BCₖ₋₁ in the previous stage as an input signal (set signal SET[k]) to shift the input signal, in synchronization with the clock signals CLK1 and CLK2, respectively. Further, the shift circuit BCₖ outputs the shifted signal as the output signal OUT[k].

An operation of a display device 1 having the gate driver 12 including the shift circuit BCₖ according to Embodiment 1 will be simply described with reference to FIGS. 2 and 3.

The gate driver 12 outputs a high level output signal OUT[1] of a shift circuit BC₁ to a gate line Lg1, and each transistor T1 of the pixel circuits Px(1, 1) to Px(m, 1) is turned on by the high level output signal OUT[1].

Further, the data driver 14 supplies the image signal Vdata to the pixel circuits Px(1, 1) to Px(m, 1) selected by the gate driver 12 through the data lines Ld1 to Ldm during this period, and the image signal Vdata is written to each capacitor C₁ of the pixel circuits Px(1, 1) to Px(m, 1) through each transistor T1.

The gate driver 12 sequentially outputs high level output signals OUT[2], OUT[3], ... and OUT[n] of the shift circuits BC2, BC3, ... and BCn to the gate lines Lg2, Lg3, ... and Lgn in the same manner.

When the output signals OUT[2], OUT[3], ... and OUT[n] are sequentially output to the gate lines Lg2, Lg3, ... and Lgn, the pixel circuits Px(1, 2) to Px(m, 2), Px(1, 3) to Px (m, 3), ... and Px(1, n) to Px (m, n) are selected, and the data driver 14 applies the image data Vdata by the supplied pixel data to the data lines Ld1 to Ldm, respectively to write the image data Vdata to the capacitor C1 of each of the selected pixel circuits Px(1, 2) to Px(m, 2), Px(1, 3) to Px(m, 3), ... and Px(1, n) to Px(m, n).

When the writing is completed as described above, the controller 15 controls a light emitting operation.

The anode driver 13 outputs high level signals Vsource(1) to Vsource (n) to anode lines La(1) to La (n) . Thereby, the transistor T2 of the pixel circuit Px(i, j) uses a voltage held by each capacitor C₁ as a gate voltage to supply a current corresponding to the gate voltage Vgs to the organic EL device 101, and the organic EL device 101 emits light at a brightness corresponding to a value of the current.

As described above, the set signal SET[k] serves as a signal for increasing the potential of the node Q from a low level to a high level so that the high level output signal OUT[k] is generated to allow the gate line Lgk corresponding to the shift circuit BCₖ to be selected, and the reset signal RST[k] serves as a signal for reversing the high level potential to the low level potential. In addition, during a period in which the potential of the node Q is at the high level, the clock signal CLK1 becomes a high level, such that the shift circuit BCₖ outputs the active output signal OUT[k] to allow the corresponding gate line Lgk to be selected.

Further, in the present embodiment, except for the period in which the clock signal CLK is output as the output signal OUT[k], the output terminal OUT is maintained as a reference voltage applied to the reference voltage terminal Vss by the pull-down transistor T₁₅, and the reference voltage and the threshold voltage of the TFT have a relationship that the reference voltage > the threshold voltage Vth of the TFT. Thus, even when the threshold voltage Vth of each TFT included in the shift register is lower than 0 V, a turn off operation of the TFT is not completely performed, and thereby preventing a voltage other than the normal output signal OUT[k] from being output to the output terminal OUT.

### 2. Embodiment 2

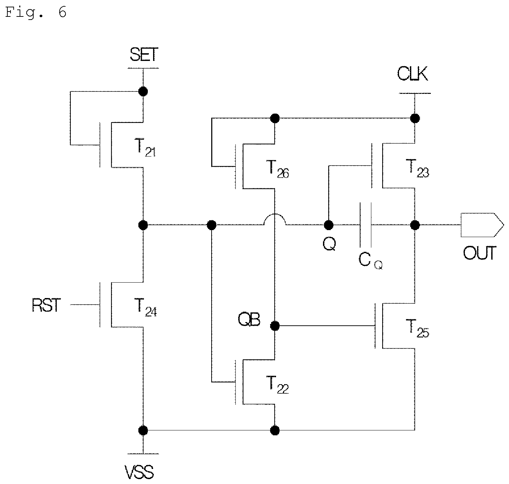

Embodiment 2 of the present invention will be described. FIG. 6 is a diagram showing a configuration of a shift circuit according to Embodiment 2 of the present invention.

As shown in FIG. 6, a shift circuit BCₖ according to Embodiment 2 has six transistors T₂₁ to T₂₆, one capacitor C_{Q}, four input terminals and one output terminal.

In the present embodiment, the five transistors T₂₁ to T₂₅ are substantially the same as the five transistors T₁₁ to T₁₅ of Embodiment 1, the capacitor C_{Q} is the same as the capacitor C_{Q} of Embodiment 1, and the four input terminals and the one output terminal are also the same as the four input terminals and the one output terminal of Embodiment 1, respectively.

A difference between Embodiment 1 and Embodiment 2 is that in Embodiment 2, an inverting transistor T₂₆ having a diode-connected structure, in which a gate terminal and a drain terminal thereof are connected to the clock input terminal CLK, and a source terminal thereof is connected to a gate terminal of the pull-down transistor T₂₅, is added between the clock input terminal CLK and the gate terminal of the pull-down transistor T₁₅ in the shift circuit BCₖ of Embodiment 1. By the difference, a potential of a node QB that is the gate terminal of the pull-down transistor T₂₅ has an inverse relationship with the potential of the node Q. Other configurations are the same as those of Embodiment 1, and will not be described in detail.

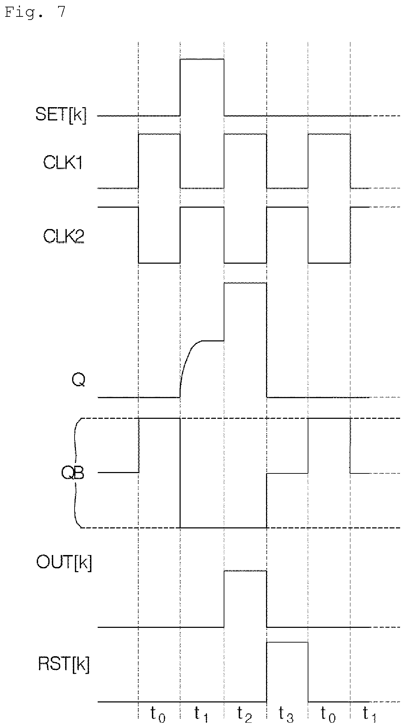

Next, an operation of the shift circuit BCₖ according to Embodiment 2 will be described in detail with reference to FIGS. 6 and 7. FIG. 7 is a timing chart showing the operation of the shift circuit of FIG. 6.

First, in a period to of FIG. 7, since a set signal SET[k] applied to a set signal input terminal SET and a reset signal RST[k] applied to a reset input terminal RST are maintained at a low level, and a high level clock signal CLK1 is applied to the clock input terminal CLK, the potential of the node QB becomes a high level by the clock signal CLK1 through the inverting transistor T₂₆ having the diode-connected structure, such that the pull-down transistor T₂₅ is turned on, and the node Q is at a low level state. Thus, an output terminal OUT becomes a low level state, that is, a state in which no signal is output, by a voltage of a reference potential applied to a reference voltage terminal Vss.

Next, in a period t₁ of FIG. 7, the set signal SET[k] is applied to the set signal input terminal SET, and a diode-connected set transistor T₂₁ is turned on to charge the capacitor C_{Q}, and thereby, the potential of the node Q is changed from a low level to a high level, such that a first switching transistor T₂₂ and an output control transistor T₂₃ are turned on. However, in the period t₁, since the clock signal CLK1 applied to the clock input terminal CLK is at a low level state, the output signal OUT[k] is maintained at a low level.

Further, in the period t₁, since the clock signal CLK1 applied to the clock input terminal CLK is at a low level, the potential of the node QB is changed to a low level.

Next, in a period t₂ of FIG. 7, the clock signal CLK1 applied to the clock input terminal CLK is increased to a high level. In this case, since the output control transistor T₂₃ is in a turn on state, a potential of the output terminal OUT is also increased, and the potential of the node Q is also increased by the capacitor C_{Q} (i.e. the node Q is bootstrapped). Therefore, a gate terminal of the output control transistor T₂₃ is applied with a potential obtained by adding a potential of the clock signal CLK1 to the potential of the set signal SET[k] charged in the capacitor C_{Q} in the period t₁. As a result, the output control transistor T₂₃ allows the clock signal CLK1 to be output as the output signal OUT[k] without loss through the output terminal OUT, such that a gate line Lgk connected to the output terminal OUT of the shift circuit BCₖ is selected.

In this case, the first switching transistor T₂₂ is continuously maintained in the turn on state, and thus the pull-down transistor T₂₅ is continuously maintained in a turn off state.

Next, in a period t₃, when a high level reset signal RST[k] is input to the reset input terminal RST, the reset transistor T₂₄ is turned on, and thus the potential of the node Q is changed to a low level, such that the first switching transistor T₂₂ and the output control transistor T₂₃ are turned off, and a potential of the output terminal OUT falls to a low level, therefore, the output of the output signal OUT[k] stops.

As described above, also in the present embodiment, the set signal SET[k] serves as a signal for increasing the potential of the node Q from a low level to a high level so that the high level output signal OUT[k] is generated to allow the gate line Lgk corresponding to the shift circuit BCₖ to be selected, and the reset signal RST[k] serves as a signal for reversing the high level potential to the low level potential. In addition, during a period in which the potential of the node Q is at the high level, the clock signal CLK1 becomes a high level, such that the shift circuit BCₖ outputs the active output signal OUT[k] to allow the corresponding gate line Lgk to be selected.

Further, in the present embodiment, the node QB is maintained at a low level during the period in which the potential of the node Q is at the high level, and in particular, the node QB is reliably maintained at a high level by the inverting transistor T₂₆ having the diode-connected structure when the clock signal CLK1 is applied to the clock input terminal CLK, such that except for the period in which the clock signal CLK is output as the output signal OUT[k], the output terminal OUT is maintained as a reference voltage applied to the reference voltage terminal Vss by the pull-down transistor T₂₅, and the reference voltage and the threshold voltage of the TFT have a relationship that the reference voltage > the threshold voltage Vth of the TFT. Thus, even when the threshold voltage Vth of each TFT included in the shift register is lower than 0 V, a turn off operation of the TFT is not completely performed, thereby preventing a voltage other than the normal output signal OUT[k] from being output to the output terminal OUT.

Since an operation of a display device 1 including the shift circuit BCₖ according to Embodiment 2 of the present invention is the same as that of Embodiment 1, and will not be described in detail.

### 3. Embodiment 3

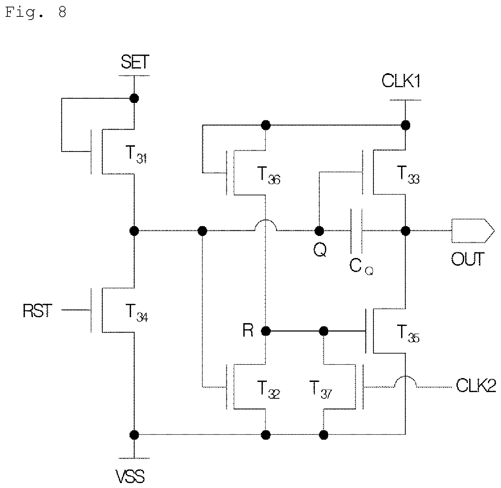

Embodiment 3 of the present invention will be described. FIG. 8 is a diagram showing a configuration of a shift circuit according to the preferred Embodiment 3 of the present invention.

As shown in FIG. 8, a shift circuit BCₖ according to Embodiment 3 includes seven transistors T₃₁ to T₃₇, one capacitor C_{Q}, four input terminals and one output terminal.

In the present embodiment, the five transistors T₃₁ to T₃₅ are substantially the same as the five transistors T₂₁ to T₂₅ of Embodiment 2, the capacitor C_{Q} is the same as the capacitor C_{Q} of Embodiment 1, and the four input terminals and the one output terminal are also the same as the four input terminals and the one output terminal of Embodiment 1, respectively.

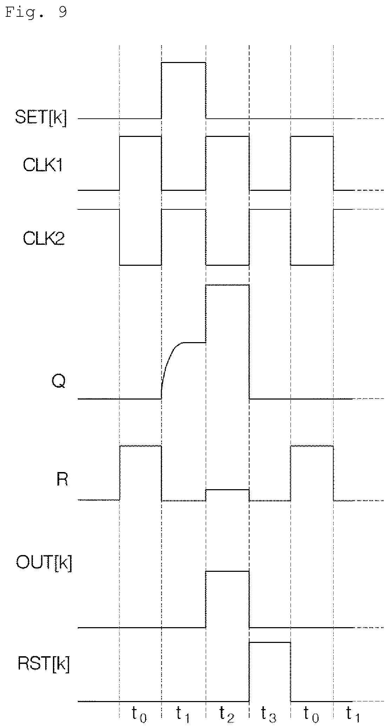

However, there are differences between Embodiment 2 and Embodiment 3 as follows. First, a second switching transistor T₃₆ of Embodiment 3 has the same connection structure as the inverting transistor T₂₆ of Embodiment 2, but has a different function therefrom in an aspect that this transistor does not serve to reverse the potential of the node QB in Embodiment 2, but serves to change a potential of a node R to a low level as shown in FIG. 9. Second, in Embodiment 3, a third switching transistor T₃₇ is added between the node R that is the gate terminal of the pull-down transistor T₂₅ in the shift circuit BCₖ of Embodiment 2 and the reference voltage terminal Vss, and a gate terminal of the third switching transistor T₃₇ is applied with a clock signal CLK2 of a shift circuit BCₖ₊₁ in a next stage, thereby decreasing stress applied to a pull-down transistor T₃₅. Other configurations are the same as those of Embodiment 2, and will not be described in detail.

Next, an operation of the shift circuit BCₖ according to Embodiment 3 will be described in detail with reference to FIGS. 8 and 9. FIG. 9 is a timing chart showing an operation of the shift circuit of FIG. 8.

First, in a period to of FIG. 9, since a set signal SET[k] applied to a set signal input terminal SET and a reset signal RST[k] applied to a reset input terminal RST are maintained at a low level, and a high level clock signal CLK1 is applied to the clock input terminal CLK, the potential of the node R becomes a high level by the clock signal CLK1 applied through the second switching transistor T₃₆ having a diode-connected structure, such that the pull-down transistor T₃₅ is turned on, and the node Q is at a low level state. Thus, an output terminal OUT becomes a low level state, that is, a state in which the output signal OUT[k] is not output, by a voltage of a reference potential applied to a reference voltage terminal Vss.

Next, in a period t₁ of FIG. 9, the set signal SET[k] is applied to the set signal input terminal SET, and a diode-connected set transistor T₃₁ is turned on to charge the capacitor C_{Q}, and thereby, the potential of the node Q is changed from a low level to a high level, such that a first switching transistor T₃₂ is turned on, and the third switching transistor T₃₇ is turned on by the high level clock signal CLK2 applied to the gate terminal of the third switching transistor T₃₇. Therefore, the node R is changed to be a low level state, and thus the pull-down transistor T₃₅ is turned off.

Next, in a period t₂ of FIG. 9, the clock signal CLK1 applied to the clock input terminal CLK is increased to a high level and the potential of the node Q is also increased by the capacitor C_{Q} (i.e. the node Q is bootstrapped). Therefore, a gate terminal of an output control transistor T₃₃ is applied with a potential obtained by adding a potential of the clock signal CLK1 to a potential of the set signal SET[k] charged in the capacitor C_{Q} in the period t₁. As a result, the output control transistor T₃₃ allows the clock signal CLK1 to be output as the output signal OUT[k] without loss through the output terminal OUT, such that a gate line Lgk connected to the output terminal OUT of the shift circuit BCₖ is selected.

In this case, the first switching transistor T₃₂ is continuously maintained in the turn on state, and the potential of the node R is also continuously maintained at a low level, thus the pull-down transistor T₃₅ is also continuously maintained in the turn off state.

Next, in a period t₃, when a high level reset signal RST[k] is input to the reset input terminal RST, a reset transistor T₃₄ is turned on, and thus the potential of the node Q is changed to a low level, such that the output control transistor T₃₃ is turned off, and a potential of the output terminal OUT falls to a low level, therefore, the output of the output signal OUT[k] stops.

In this case, since the potential of the node Q is changed to a low level, the first switching transistor T₃₂ is also turned off, but a clock signal CLK2 of a shift circuit BCₖ₊₁ in a next stage is applied to the gate terminal of the third switching transistor T₃₇, such that the pull-down transistor T₃₅ is maintained in a turn off state by a voltage of a reference potential applied through the third switching transistor T₃₇.

As described above, also in the present embodiment, the set signal SET[k] serves as a signal for increasing the potential of the node Q from a low level to a high level so that the high level output signal OUT[k] is generated to allow the gate line Lgk corresponding to the shift circuit BCₖ to be selected, and the reset signal RST[k] serves as a signal for reversing the high level potential to the low level potential. In addition, during the period in which the potential of the node Q is at the high level, the clock signal CLK1 becomes a high level, such that the shift circuit BCₖ outputs the active output signal OUT[k] to allow the corresponding gate line Lgk to be selected.

Further, according to the present embodiment, in periods other than the period to, the pull-down transistor T₃₅ is turned off by the third switching transistor T₃₇, such that it is possible to solve a problem that excessive stress is applied to the pull-down transistors T₁₅ and T₂₅ due to the pull-down transistors T₁₅ and T₂₅ are maintained in an activated state (turn on state) in periods other than the period t₂ that is a period in which the output signal OUT[k] is output to the output terminal OUT, and thereby improving stability of the shift register.

An operation of a display device 1 including the shift circuit BCₖ according to Embodiment 3 of the present invention is the same as that of Embodiment 1.

### 4. Embodiment 4

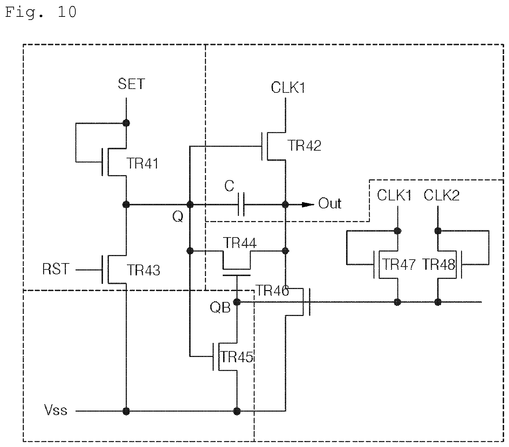

Next, a configuration of a shift circuit BCₖ according to Embodiment 4 will be described in detail with reference to FIG. 10. FIG. 10 is a diagram showing a configuration of a shift circuit according to the preferred Embodiment 4 of the present invention.

As shown in FIG. 10, each shift circuit BCₖ includes an input terminal SET, an output terminal OUT, a reset terminal RST, a reference voltage terminal Vss, and two clock terminals CLK1 and CLK2 including a first clock terminal CLK1 and a second clock terminal CLK2.

The input terminal SET is a terminal to which an input signal SET[k] is supplied, and a start signal St is supplied as an input signal SET[1] to the input terminal SET of a shift circuit BC₁ which corresponds to the first shift circuit in FIG. 3 from the controller 15.

The output terminal OUT is a terminal for outputting an output signal OUT[k], and is connected to each gate line Lgk of the display device 1 to output the output signal of the shift circuit BCₖ to a switching transistor T₄₁ of a corresponding pixel circuit. Further, an input terminal of the respective shift circuits BC₂ to BCₙ from the second shift circuit is connected to an output terminal OUT of a shift circuit in a previous stage, respectively.

The reset terminal RST is a terminal to which a reset signal RST[k] is supplied, and the reset terminal RST of the respective shift circuits from the second shift circuit is connected to an output terminal OUT of a shift circuit in a next stage, respectively, and an output signal of the shift circuit in the next stage is applied as a reset signal of a shift circuit in a previous stage. Further, in a shift circuit BCₙ in the last stage, an operation of the shift register, that is an operation of the gate driver 12 ends by the end signal End or the start signal St applied from the controller 15.

The first clock terminal CLK1 of the two clock terminals CLK1 and CLK2 to which two clock signals are input, respectively, is a terminal to which a first clock signal CLK1 is applied from the controller 15, and the second clock terminal CLK2 is a terminal to which a second clock signal CLK2 is applied.

The reference voltage terminal Vss is a terminal to which a low level voltage as a reference voltage is applied. It is preferable that the low level voltage as a reference voltage is a voltage lower than a threshold voltage of an oxide transistor, in consideration of the threshold voltage of the oxide transistor in a case in which each of the transistors TR41 to TR48 included in each shift circuit of the present embodiment is formed by the oxide transistor.

The shift circuit BCₖ includes eight transistors TR41 to TR48 and one capacitor C, and each of the transistors TR41 to TR48 is an n-channel FET formed by an oxide TFT.

The eight transistors TR41 to TR48 have a drain electrode, a source electrode, and a gate electrode, respectively, in which a semiconductor layer is disposed between the drain electrode and the source electrode, and when a predetermined bias voltage is applied between the drain and the source and a voltage larger than a threshold voltage is applied to the gate, a channel is formed in the semiconductor layer to form a current path between the drain and the source by the channel.

A first input transistor TR41 determines a potential of the node Q according to a signal level of the input signal SET[k] applied to the input terminal SET, a gate electrode and a drain electrode of the first input transistor TR41 are connected to the input terminal SET, and a source electrode thereof is connected to the node Q and is connected to a drain electrode of a second input transistor TR43.

The second input transistor TR43 is a transistor for resetting the shift circuit BCₖ by a high level signal supplied to the reset terminal RST, wherein a gate electrode of the second input transistor TR43 is connected to the reset terminal RST, a drain electrode thereof is connected to the node Q and the source electrode of the first input transistor TR41, and the source electrode thereof is connected to the reference voltage terminal Vss together with source electrodes of an inverting transistor TR45 and a third hold transistor TR46.

By the input terminal SET, the reset terminal RST, the node Q, the first input transistor TR41, and the second input transistor TR43, an input circuit of the present invention may be formed.

An output transistor TR42 is turned on or off depending on the potential of the node Q, and the first clock signal CLK1 applied to the first clock terminal CLK1 is applied to the drain electrode thereof, such that when the output transistor TR42 is in a turn on state, the output signal OUT[k] as a shift signal is output to the output terminal OUT in synchronization with the clock signal.

The output transistor TR42 is turned on or off depending on the potential of the node Q, and when the output transistor TR42 is in a turn on state, the output signal OUT[k] as a shift signal is output to the output terminal OUT in synchronization with the first clock signal CLK1 applied to the first clock terminal CLK1.

A gate electrode of the output transistor TR42 is connected to the node Q, the drain electrode thereof is connected to the first clock terminal CLK1, and a source electrode thereof is connected to the output terminal OUT, and is connected to a source electrode of a fourth hold transistor TR44 and a drain electrode of the third hold transistor TR46. Further, a capacitor C generating a bootstrap effect is connected between the gate electrode and a source electrode of the output transistor TR42.

By the first clock terminal CLK1, the output terminal OUT, and the output transistor TR42, an output circuit of the present invention may be formed.

The inverting transistor TR45 is turned on as the first input transistor TR41 is turned on together with the output transistor TR42 such that a potential of an inverting node QB is maintained at a low level, a gate electrode thereof is connected to the node Q, a drain electrode thereof is connected to the inverting node QB, and the source electrode thereof is connected to the reference voltage terminal Vss.

Herein, the inverting node QB is a terminal having a potential that is reverse to the potential of the node Q, that is, when the potential of the node Q is a high level potential, the potential of the inverting node QB is a low level potential, and when the potential of the node Q is a low level potential, the potential of the inverting node QB is a high level potential. An operation thereof will be described in detail below.

By the inverting node QB, the reference voltage terminal Vss, and the inverting transistor TR45, an inverting circuit of the present invention may be formed.

A first hold transistor TR47 has a gate electrode and a drain electrode connected to the first clock terminal CLK1, and a source electrode connected to a gate electrode of the third hold transistor TR46 and the inverting node QB, and is operated by the first clock signal CLK1 applied to the first clock terminal CLK1 to reverse the potential of the inverting node QB to a high level.

A second hold transistor TR48 has a gate electrode and a drain electrode connected to the second clock terminal CLK2, and a source electrode connected to the gate electrode of the third hold transistor TR46 and the inverting node QB, and is operated by the second clock signal CLK2 applied to the second clock terminal CLK2 to reverse the potential of the inverting node QB to a high level.

The gate electrode of the third hold transistor TR46 is connected to the inverting node QB, and is connected to the first clock terminal CLK1 and the second clock terminal CLK2 through the first hold transistor TR47 and the second hold transistor TR48, the drain electrode thereof is connected to the output terminal OUT, and a source electrode thereof is connected to a source electrode of the inverting transistor TR45 together with the reference voltage terminal Vss.

Further, the third hold transistor TR46 is turned on by the first clock signal CLK1 applied to the first clock terminal CLK1 when the potential of the inverting node QB is the high level, and allows the potential of the output terminal OUT to fall to the potential of the reference voltage terminal Vss, and thereby preventing the voltage from being output to the output terminal OUT even when the threshold voltage of the output transistor TR42 is equal to or lower than 0 V.

A gate electrode of the fourth hold transistor TR44 is connected to the inverting node QB to allow the output transistor TR42 to be in a diode state when the potential of the inverting node QB is the high level, a drain electrode thereof is connected to the node Q, and the source electrode thereof is connected to the output terminal OUT. Further, the output terminal OUT is also connected to the other end of the capacitor C, the source electrode of the output transistor TR42, and the drain electrode of the third hold transistor TR46.

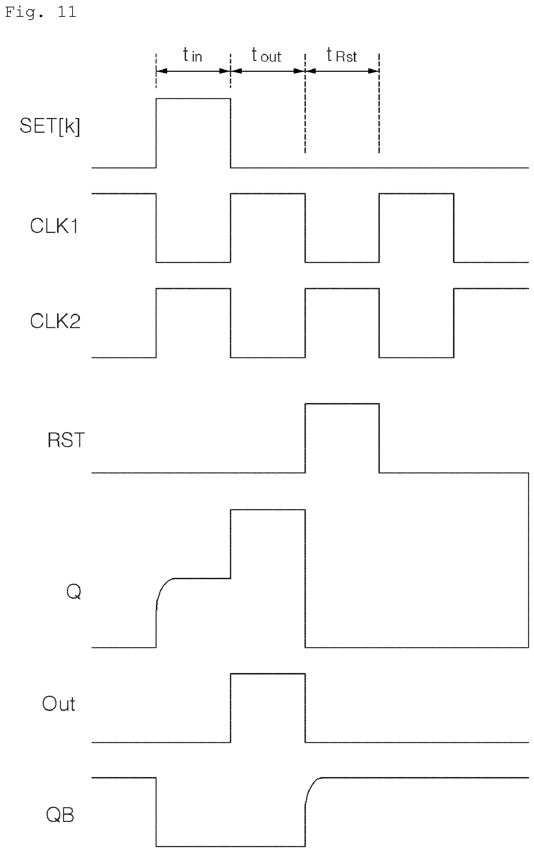

Hereinafter, an operation of the shift circuit BCₖ according to Embodiment 4 will be described. FIG. 11 is a timing chart showing an operation of the shift circuit of FIG. 10.

The controller shown in FIG. 2 supplies the first clock signal CLK1 and the second clock signal CLK2 that have phases different from each other by 180 degrees and the high level start signal St to the gate driver 12, and when the first clock signal CLK1 is a low level, the high level start signal St is supplied to the input terminal SET of the shift circuit BC₁ in a first stage as an input signal SET[1], such that the first input transistor TR41 of the shift circuit BC₁ having a diode structure is turned on. A period in which the high level start signal St is supplied is an input period tᵢₙ.

When the first input transistor TR41 is turned on, the potential of the node Q becomes a high level, such that the output transistor TR42 and the inverting transistor TR45, of which the gate electrodes are connected to the node Q, respectively, are tuned on. As the inverting transistor TR45 is turned on, the potential of the inverting node QB becomes a potential applied to the reference voltage terminal Vss, that is, an off-potential. As a result, the third hold transistor TR46 is also turned off.

Next, in an output period tₒᵤₜ, when the first clock signal CLK1 is increased to a high level, and the second clock signal CLK2 is decreased to a low level, the first clock signal CLK1 is output through the output terminal OUT as an output signal OUT[1] through the output transistor TR42 that is in a turn on state. In this case, since a potential of the first clock signal CLK1 is the high level potential, the node Q is bootstrapped as much as the first clock signal CLK1 by the capacitor C connected between the gate electrode and the source electrode of the output transistor TR42, and a gate voltage of the output transistor TR42 is increased as much as a voltage of the first clock signal CLK1. Therefore, the first clock signal CLK1 is reliably output through the output terminal OUT as an output signal OUT[1] without loss through the output transistor TR42.

The high level output signal OUT[1] is output to a gate line Lg1, and is supplied to a shift circuit BC₂ in a next stage as an input signal SET[2], and the shift circuit BC₂ shifts the input signal SET[2] in synchronization with the second clock signal CLK2 to output a high level output signal OUT[2].

In the output period tₒᵤₜ, the gate electrode and the drain electrode of the first hold transistor TR47 having a diode structure are also supplied with the first clock signal CLK1, but since the gate voltage of the inverting transistor TR45 is higher than the potential of the first clock signal CLK1 by the bootstrap, the inverting transistor TR45 is continuously maintained in the turn on state, and the potential of the inverting node QB is also continuously maintained at a low level.

Further, when the node Q is bootstrapped, the gate voltage of the inverting transistor TR45 is further increased, such that the potential of the inverting node QB is also continuously maintained in the turn off state.

Further, the high level output signal OUT[2] is supplied to the reset terminal RST of the shift circuit BC₁ as a reset signal RST[1] of the shift circuit BC₁ in a previous stage.

Next, in a reset period t_{RST}, when the reset signal RST[1] is applied to the reset terminal RST of the shift circuit BC₁, the second input transistor TR43 is turned on, such that the potential of the node Q falls to a low level by a low level voltage supplied from the reference voltage terminal Vss, and the output transistor TR42 and the inverting transistor TR45 are turned off.

Simultaneously, in the reset period t_{RST}, the first clock signal CLK1 is changed to a low level, and the second clock signal CLK2 is changed to a high level. Thereby, as the high level second clock signal CLK2 is applied, the potential of the inverting node QB becomes a high level, such that the third hold transistor TR46 is turned on, and the fourth hold transistor TR44 is also turned on, and as the fourth hold transistor TR44 is turned on, the output transistor TR42 may have a diode-connected structure.

Accordingly, even when the first clock signal CLK1 is changed to a high level at a next timing, except during the period in which the potential of the node Q is at the high level, that is, when the input signal SET[k] is not applied to the input terminal SET, the potential of the output terminal OUT is continuously maintained at a low level, and thereby, a problem that the voltage is output to the output terminal OUT even in the case in which the threshold voltage of the output transistor TR42 is equal to or lower than 0 V, for example, such as the case in which the oxide transistor is used as the output transistor TR42, may be reliably prevented.

Further, the inverting node QB is always maintained at a high level potential except during the period in which the potential of the node Q is at the high level, that is, when the high level input signal SET[k] is applied to the input terminal SET, thereby preventing ripple from being output to the output terminal OUT.

Similar to the above operation, the shift circuit BCₖ (k = 2 to n) uses an output signal OUT[k-1] output from a shift circuit BCₖ₋₁ as an input signal SET[k] to shift the input signal SET[k], in synchronization with the first and second clock signals CLK1 and CLK2, respectively. Further, the shift circuit BCₖ outputs the shifted signal as the output signal OUT[k].

An operation of a display device 1 including the shift circuit BCₖ according to Embodiment 4 of the present invention is the same as that of Embodiment 1.

Hereinabove, the embodiments of the present invention have been described, but the present invention is not limited thereto.

In the embodiments, the case in which the display device of the present invention is the display device including the organic EL device has been described, but the display device is not limited thereto, and any display device may be used so long as it includes a light emitting device. For example, a liquid crystal display device including a liquid crystal device may also be used.

Further, in the embodiments, the case in which each of the transistors included in the shift circuit is an n-channel FET has been described, but the transistor may also be a p-channel FET. In this case, as a control signal supplied to a control electrode (gate) of each transistor, a signal that is reverse to that of the case of the n-channel FET may be supplied.

Furthermore, in the embodiment, the case in which the transistor included in the shift circuit is an oxide thin film transistor has been described by way of example, but the present invention is not limited thereto, and other types of transistor may also be used.

## Claims

1. A shift circuit of a shift register including a plurality of shift circuits that are cascade-connected, the shift circuit comprising:
an input circuit which includes an input terminal to which an output signal of a shift circuit in a previous stage is supplied as an input signal, a reset terminal to which an output signal of a shift circuit in a next stage is supplied as a reset signal, and a first node, and is configured to set a potential of the first node as a potential of the input signal, as the input signal is input;
an inverting circuit including a second node and a reference voltage terminal, wherein the second node is configured to have a potential that is reverse to the potential of the first node obtained by reversing the potential of the first node;
an output circuit which includes a first clock terminal to which a first clock signal is supplied, and an output terminal which outputs the output signal, and is configured to output a potential of the output signal as a potential according to the first clock signal to the output terminal depending on the potential of the first node and the potential of the second node; and
a hold circuit configured to maintain the potential of the second node as a high level potential when the potential of the first node is not the potential of the input signal.

2. The shift circuit of claim 1, wherein the input circuit comprises: a first input transistor configured to be turned on when the input signal is input to the input terminal so as to set the potential of the first node as the potential of the input signal; and
a second input transistor configured to be turned on when the reset signal is input to the reset terminal so as to reverse the potential of the first node.

3. The shift circuit of claim 1, wherein the output circuit comprises: an output transistor of which a gate electrode is connected to the first node, to form a current path between the first clock terminal and the output terminal; and
a capacitor connected between the gate electrode and a source electrode of the output transistor.

4. The shift circuit of claim 1, wherein the inverting circuit comprises an inverting transistor of which a gate electrode is connected to the first node, to form a current path between the second node and the reference voltage terminal.

5. The shift circuit of claim 1, wherein the hold circuit comprises: a first hold transistor configured to form a current path between the first clock terminal and the second node;
a second hold transistor configured to form a current path between a second clock terminal which inputs a second clock signal of a signal having a level reverse to that of the first clock signal and the second node;
a third hold transistor of which a gate electrode is connected to the second node, to form a current path between the output terminal and the reference voltage terminal; and
a fourth hold transistor of which a gate electrode is connected to the second node, to form a current path between the output transistor, the first node and the output terminal.

6. A shift circuit of a shift register which has a first state and a second state and includes a plurality of shift circuits that are cascade-connected, the shift circuit comprising:
an output terminal configured to output a state signal indicating any one of the first state and the second state;
an output control transistor in which a clock signal is applied to a second electrode, and a third electrode is connected to the output terminal;
a charge means connected between a first electrode and a first node of the output control transistor;
a set transistor configured to activate the first node based on a state signal output from a shift circuit in a previous stage of the plurality of shift circuits, and charge the charge means; and
a reset transistor configured to deactivate the first node based on a state signal output from a shift circuit in a next stage of the plurality of shift circuits.

7. The shift circuit of claim 6, further comprising:
a first switching transistor configured to be turned on when the first node is activated; and
a pull-down transistor configured to apply a voltage of a reference potential to the output terminal when the first switching transistor is turned on.

8. The shift circuit of claim 7, further comprising:
an inverting transistor which is connected between the second electrode of the output control transistor and a first electrode of the pull-down transistor, and is configured to turn on the pull-down transistor by the clock signal.

9. The shift circuit of claim 7, further comprising:
a second switching transistor which is connected between the second electrode of the output control transistor and a first electrode of the pull-down transistor, and is configured to turn on the pull-down transistor by the clock signal; and
a third switching transistor configured to be turned on by a clock signal in a next stage of the plurality of shift circuits to apply a voltage of a referent potential to a first electrode of the pull-down transistor.

10. The shift circuit of any one of claims 2 to 9, wherein each transistor included in the shift circuit is an oxide thin film transistor.

11. A shift register comprising a plurality of shift circuits that are cascade-connected,
wherein each of the plurality of shift circuits includes the shift circuit of any one of claims 1 to 10.

12. A display device including a light emitting device, the display device comprising: a plurality of pixel circuits disposed in a matrix form; and
the shift register of claim 11,
wherein the plurality of pixel circuits are selected in a row unit by using an output signal of each of the plurality of shift circuits included in the shift register as a row selection signal for selecting a row of the display device.
